(19)

**Europäisches Patentamt**
**European Patent Office**
**Office européen des brevets**

(11) **EP 4 011 931 A1**

(12) **EUROPEAN PATENT APPLICATION**

(43) Date of publication:
**15.06.2022 Bulletin 2022/24**

(21) Application number: **21212514.0**

(22) Date of filing: **06.12.2021**

(51) International Patent Classification (IPC):
**C08G 59/68** (2006.01)       **C08G 65/18** (2006.01)
**C09D 171/02** (2006.01)       **C09D 133/06** (2006.01)

(52) Cooperative Patent Classification (CPC):
(C-Sets available)
**C08G 65/18; C08G 59/68; C09D 171/02**       (Cont.)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **09.12.2020   JP 2020204171
07.10.2021   JP 2021165320**

(71) Applicant: **NITTO DENKO CORPORATION
Ibaraki-shi
Osaka 567-8680 (JP)**

(72) Inventors:
• **Ikeda, Jun**
  **Ibaraki-shi (JP)**
• **Kimura, Ryuichi**
  **Ibaraki-shi (JP)**

(74) Representative: **Grünecker Patent- und
Rechtsanwälte
PartG mbB
Leopoldstraße 4
80802 München (DE)**

(54) **PHOTOCURABLE RESIN SHEET**

(57)      The present invention provides a photocurable resin sheet excellent in handleability, photocurability, and transparency. Included is a photocurable resin sheet containing a high molecular compound (A) and a low molecular compound (B), wherein an epoxy group, an oxetanyl group, and a photopolymerization initiating group are each individually present in the high molecular compound (A) or the low molecular compound (B).

EP 4 011 931 A1

**(Cont. next page)**

(52) Cooperative Patent Classification (CPC): (Cont.)

C-Sets
**C09D 171/02, C08L 33/068**

**Description**

TECHNICAL FIELD

The present invention relates to a photocurable resin sheet.

BACKGROUND ART

Conventionally, photocurable resin compositions have been widely used in optical applications such as adhesives for displays or optical semiconductors, lenses, and protective films. Most of these resin compositions are liquid at normal temperature (25°C) and used by dispensing methods.

Patent Literature 1, for example, discloses an optical photosensitive resin composition which achieves both high photocurability and high transparency by combining a dicyclopentadiene type epoxy resin having no aromatic ring and a monofunctional oxetane resin having no aromatic ring as resins curable by a photoacid generator. However, the resin composition is liquid at normal temperature and therefore cannot be formed into a sheet. In addition, the resin composition incapable of maintaining its shape has the problem of poor handleability because it may have an uneven thickness when applied to a substrate or may flow out from between adherends when used as an adhesive.

Moreover, Patent Literature 2 discloses a photocurable resin composition sheet containing a solid epoxy resin, a liquid epoxy resin, and a photoacid generator, which is excellent in properties such as transparency and heat resistance. However, disadvantageously, the photocurable resin composition sheet is poor in photocurability.

CITATION LIST

- Patent Literature

> Patent Literature 1: JP 2017-141356 A
> Patent Literature 2: JP 2015-96571 A

SUMMARY OF INVENTION

- Technical Problem

The present invention aims to provide a photocurable resin sheet excellent in handleability, photocurability, and transparency.

- Solution to problem

Specifically, the present invention relates to a photocurable resin sheet, containing a high molecular compound (A) and a low molecular compound (B), wherein an epoxy group, an oxetanyl group, and a photopolymerization initiating group are each individually present in the high molecular compound (A) or the low molecular compound (B).

Preferably, the high molecular compound (A) has a weight average molecular weight of 1,000 to 1,000,000.

Preferably, the low molecular compound (B) has a molecular weight of less than 1,000.

Preferably, the photocurable resin sheet has a storage modulus G' at 25°C of 50,000 Pa or higher.

Preferably, a cured product of the photocurable resin sheet at 25°C has an optical transmittance at a wavelength of 400 nm of 70% or higher and a refractive index with respect to light at a wavelength of 589 nm of 1.40 or higher.

Preferably, the high molecular compound (A) includes at least one selected from the group consisting of poly(meth)acrylic resins, phenoxy resins, polyurethane resins, silicone resins, polyester resins, polyamide resins, and polyimide resins.

Preferably, the low molecular compound (B) includes a compound containing an oxetanyl group.

Preferably, the low molecular compound (B) includes a photoacid generator.

The present invention also relates to an optical material obtained by curing the photocurable resin sheet of the present invention.

- Advantageous Effects of Invention

The photocurable resin sheet of the present invention is capable of maintaining its shape without becoming liquid at normal temperature even before curing, and therefore has excellent handleability as well as excellent photocurability and transparency. Moreover, the photocurable resin sheet has improved moldability and workability such as facilitating collective sealing or fine control of thickness, and therefore has improved productivity of products as well.

DESCRIPTION OF EMBODIMENTS

The photocurable resin sheet of the present invention contains a high molecular compound (A) and a low molecular compound (B). Further, an epoxy group, an oxetanyl group, and a photopolymerization initiating group are each individually present in the high molecular compound (A) or the low molecular compound (B).

By "an epoxy group, an oxetanyl group, and a photopolymerization initiating group are each individually present in the high molecular compound (A) or the low molecular compound (B)", as used herein, it is meant that each of the groups is present in either of the compounds irrespective of the other groups. For example, there may be a case where an epoxy group is present in a high molecular compound (A), an oxetanyl group is present in a low molecular compound (B1), and a photopolymerization initiating group is present in a low molecular compound (B2) or a case where an epoxy group, an oxetanyl group, and a photopolymerization initiating group are each present in one high molecular compound (A).

High molecular compound (A)

The high molecular compound (A) may have any weight average molecular weight, but the weight average molecular weight is preferably 1,000 to 1,000,000, more preferably 10,000 to 100,000. A high molecular compound (A) having a weight average molecular weight of less than 1,000 may be liquid at normal temperature, failing to maintain a sheet shape. A high molecular compound (A) having a weight average molecular weight of more than 1,000,000 may not be dissolved in a solvent, failing to be processed into a sheet shape. The high molecular compound (A) may be a single compound or a combination of two or more compounds. As used herein, the weight average molecular weight of the high molecular compound is determined by dissolving the high molecular compound in tetrahydrofuran and measuring the solution under the following conditions using a GPC device (HLC-8320 GPC, Tosoh Corporation) relative to polystyrene standards.

Column: TSKgel Super HZMH/HZ4000/HZ3000/HZ2000
Column size:

$$6.0 \ \mathtt{mm \ I.D. \ \times \ 150 \ mm}$$

Eluent: THF
Flow rate: 0.6 mL/min
Detector: RI
Column temperature: 40°C
Injection amount: 20 $\mu$L

The high molecular compound (A) may have any glass transition temperature (Tg). In order to achieve higher handleability and storage modulus G', the glass transition temperature is preferably -20°C or higher, more preferably -10°C or higher, still more preferably 0°C or higher, particularly preferably 5°C or higher, most preferably 10°C or higher. The upper limit of the glass transition temperature is not limited but is preferably 100°C or lower, more preferably 80°C or lower, still more preferably 60°C or lower.

As used herein, the glass transition temperature (Tg) of the high molecular compound refers to the temperature at which a loss tangent (tan$\delta$) peak is exhibited in DMA (tensile test) under conditions including a rate of temperature rise of 5°C/min, a sample width of 5 mm, a distance between chucks of 20 mm, and a frequency of 10 Hz.

Non-limiting examples of the high molecular compound (A) include poly(meth)acrylic resins, phenoxy resins, polyurethane resins, silicone resins, polyester resins, polyamide resins, and polyimide resins. Among these, poly(meth)acrylic resins are preferred from the standpoint of photocurability and solubility in a solvent.

Examples of the poly(meth)acrylic resins include polymers polymerized from (meth)acrylic acid esters as monomers such as (meth)acrylic acid alkyl esters, (meth)acrylic acid cycloalkyl esters, (meth)acrylic acid aryl esters. The term "(meth)acrylic" as used herein means acrylic and/or methacrylic.

Examples of the (meth)acrylic acid alkyl esters include methyl (meth)acrylate, ethyl (meth)acrylate, propyl (meth)acrylate, isopropyl (meth)acrylate, butyl (meth)acrylate, isobutyl (meth)acrylate, s-butyl (meth)acrylate, t-butyl (meth)acrylate, pentyl (meth)acrylate, isopentyl (meth)acrylate, hexyl (meth)acrylate, heptyl (meth)acrylate, octyl (meth)acrylate, 2-ethylhexyl (meth)acrylate, isooctyl (meth)acrylate, nonyl (meth)acrylate, decyl (meth)acrylate, isodecyl (meth)acrylate, undecyl (meth)acrylate, dodecyl (meth)acrylate, tridecyl (meth)acrylate, tetradecyl (meth)acrylate, hexadecyl (meth)acrylate, octadecyl (meth)acrylate, and eicosyl (meth)acrylate. Examples of the (meth)acrylic acid cycloalkyl esters include cyclopentyl (meth)acrylate and cyclohexyl (meth)acrylate. Examples of the (meth)acrylic acid aryl esters include phenyl (meth)acrylate and benzyl (meth)acrylate. These (meth)acrylic acid esters may be used alone or in combinations of two or more.

The poly(meth)acrylic resins may also be produced by copolymerization of the aforementioned (meth)acrylic acid esters with additional monomers copolymerizable therewith. Examples of such additional monomers include carboxy group-containing monomers, acid anhydride monomers, hydroxy group-containing monomers, sulfonic acid group-containing monomers, phosphoric acid group-containing monomers, acrylamides, and acrylonitriles. Examples of the carboxy group-containing monomers include (meth)acrylic acid, carboxyethyl (meth)acrylate, carboxypentyl (meth)acrylate, itaconic acid, maleic acid, fumaric acid, and crotonic acid. Examples of the acid anhydride monomers include maleic anhydride and itaconic anhydride. Examples of the hydroxy group-containing monomers include 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, and [4-(hydroxymethyl)cyclohexyl]methyl (meth)acrylate. Examples of the sulfonic acid group-containing monomers include styrenesulfonic acid, allylsulfonic acid, 2-(meth)acrylamido-2-methylpropanesulfonic acid, (meth)acrylamidopropanesulfonic acid, and (meth)acryloyloxynaphthalenesulfonic acid. Examples of the phosphoric acid group-containing monomers include 2-hydroxyethylacryloyl phosphate. These additional monomers may be used alone or in combinations of two or more.

The poly(meth)acrylic resins may be produced by any polymerization method, including, for example, solution polymerization, emulsion polymerization, suspension polymerization, and bulk polymerization.

Examples of the phenoxy resins include polyhydroxy polyethers polymerized from bisphenols and epichlorohydrin. Examples of the bisphenols include bisphenol A and bisphenol F. Bisphenol A is preferred from the standpoint of transparency and heat resistance.

The polyurethane resins may be any resin containing a urethane bond as a repeating unit in the backbone. Examples include polymers of aliphatic or aromatic diols and aromatic or aliphatic diisocyanates. These may be used alone or in combinations of two or more.

The silicone resins may be any resin containing a siloxane bond as a repeating unit in the backbone. Examples include polymers of diphenylsilane or dimethylsilane. These may be used alone or in combinations of two or more.

The polyester resins may be any resin containing an ester bond as a repeating unit in the backbone. Examples include polymers of aliphatic or aromatic diols and aliphatic or aromatic dicarboxylic acids. These may be used alone or in combinations of two or more.

The polyamide resins may be any resin containing an amide bond as a repeating unit in the backbone. Examples include polymers of aliphatic or aromatic diamines and aliphatic or aromatic dicarboxylic acids and ring-opening polymers of cyclic lactams. These may be used alone or in combinations of two or more.

The polyimide resins may be any resin containing an imide bond as a repeating unit in the backbone. Examples include polymers of aliphatic or aromatic diamines and aliphatic or aromatic acid anhydrides. These may be used alone or in combinations of two or more.

The high molecular compound (A) may contain all of the epoxy, oxetanyl, and photopolymerization initiating groups. Alternatively, the high molecular compound (A) may contain only some of these substituents or none of these substituents. These substituents may be present in both the high molecular compound (A) and the low molecular compound (B), but the substituent(s) not present in the high molecular compound (A) should be present in the low molecular compound (B). In the case where the high molecular compound (A) contains multiple such substituents, the high molecular compound (A) does not need to be a single compound containing the multiple substituents and may be a combination of multiple compounds each containing one of the substituents. Among these substituents, the high molecular compound (A) preferably contains an epoxy group, more preferably an aliphatic epoxy group, still more preferably a glycidyl (meth)acrylate group.

When the high molecular compound (A) is a high molecular compound produced by radical polymerization, such as a poly(meth)acrylic resin, the epoxy, oxetanyl, or photopolymerization initiating group may be introduced by any method. An exemplary method includes copolymerizing a monomer containing an epoxy group, an oxetanyl group, or a photopolymerization initiating group with any of the monomers described above.

Examples of the monomer containing an epoxy group include monomers containing aliphatic epoxy groups, monomers containing alicyclic epoxy groups, and monomers containing aromatic epoxy groups. Preferred among these are monomers containing aliphatic epoxy groups.

Examples of the monomers containing aliphatic epoxy groups include (meth)acrylates of aliphatic epoxy compounds such as glycidyl ethers of polyhydric alcohols (e.g., 1,4-butanediol diglycidyl ether, 1,6-hexanediol diglycidyl ether, triglycidyl ether of glycerol, triglycidyl ether of trimethylolpropane, tetraglycidyl ether of sorbitol, hexaglycidyl ether of dipentaerythritol, diglycidyl ether of polyethylene glycol, and diglycidyl ether of polypropylene glycol), polyglycidyl ethers of polyether polyols obtained by addition of one or two or more alkylene oxides to aliphatic polyhydric alcohols (e.g., propylene glycol, trimethylolpropane, glycerol), diglycidyl esters of aliphatic long-chain dibasic acids, monoglycidyl ethers of aliphatic higher alcohols, glycidyl esters of higher fatty acids, epoxidized soybean oil, octyl epoxystearate, butyl epoxystearate, and epoxidized polybutadiene. Specific examples include epoxy group-containing (meth)acrylates such as 4-hydroxybutyl (meth)acrylate glycidyl ether and glycidyl (meth)acrylate.

Examples of the monomers containing alicyclic epoxy groups include (meth)acrylates of alicyclic epoxy compounds such as 3,4-epoxycyclohexylmethyl-3,4-epoxycyclohexane carboxylate, 3,4-epoxy-1-methylcyclohexyl-3,4-epoxy-1-methylhexane carboxylate, 6-methyl-3,4-epoxycyclohexylmethyl-6-methyl-3,4-epoxycyclohexane carboxylate, 3,4-epoxy-3-methylcyclohexylmethyl-3,4-epoxy-3-methylcyclohexane carboxylate, 3,4-epoxy-5-methylcyclohexylmethyl-3,4-epoxy-5-methylcyclohexane carboxylate, bis(3,4-epoxycyclohexylmethyl)adipate, 3,4-epoxy-6-methylcyclohexylcarboxylate, methylene-bis(3,4-epoxycyclohexane), propane-2,2-diyl-bis(3,4-epoxycyclohexane), 2,2-bis(3,4-epoxycyclohexyl)propane, dicyclopentadiene diepoxide, ethylene-bis(3,4-epoxycyclohexane carboxylate), 1-epoxyethyl-3,4-epoxycyclohexane, 1,2-epoxy-2-epoxyethylcyclohexane, and caprolactone-modified products, trimethylcaprolactone-modified products, and valerolactone-modified products of the foregoing.

Examples of the monomers containing aromatic epoxy groups include (meth)acrylates of aromatic epoxy compounds such as monoglycidyl ethers of polyether alcohols obtained by addition of alkylene oxides to phenol, cresol, or butylphenol.

Examples of the monomer containing an oxetanyl group include oxetanyl group-containing (meth)acrylates such as 3-oxetanylmethyl (meth)acrylate, 3-methyl-oxetanylmethyl (meth)acrylate, 3-ethyl-oxetanylmethyl (meth)acrylate, 3-butyl-oxetanylmethyl (meth)acrylate, and 3-hexyl-oxetanylmethyl (meth)acrylate. Examples of the monomer containing a photopolymerization initiating group include acryloyl group-containing triarylsulfonium salts.

When the high molecular compound (A) is a phenoxy resin, a polyurethane resin, a silicone resin, a polyester resin, a polyamide resin, or a polyimide resin, the epoxy, oxetanyl, or photopolymerization initiating group may be introduced by any method. An exemplary method for introducing the epoxy group includes reacting a hydroxy group-containing resin with a chloro group-containing epoxy compound such as epichlorohydrin. An exemplary method for introducing the oxetanyl group includes reacting a hydroxy group-containing resin with a chloro group-containing oxetane compound such as 3-chlorooxetane. An exemplary method for introducing the photopolymerization initiating group includes crosslinking a hydroxy group-containing resin and a hydroxy group-containing photopolymerization initiator with a poly- or diisocyanate.

In the case where the high molecular compound (A) contains an epoxy group, the epoxy equivalent of the high molecular compound (A) is not limited, but is preferably 100 to 10,000 g/eq, more preferably 100 to 1,000 g/eq. When the epoxy equivalent is less than 100 g/eq, the density of epoxy groups may be too high, so that the reaction may not be completed due to the steric hindrance between side chains. When the epoxy equivalent is more than 10,000 g/eq, the density of epoxy groups may be too low to allow the reaction to proceed.

As used herein, the epoxy equivalent of the high molecular compound (A) is measured in conformity with JIS K7236 (2001).

In the case where the high molecular compound (A) contains an oxetanyl group, the oxetanyl equivalent of the high molecular compound (A) is not limited, but is preferably 100 to 10,000 g/eq, more preferably 100 to 1,000 g/eq. When the oxetanyl equivalent is less than 100 g/eq, the density of oxetanyl groups may be too high, so that the reaction may not be completed due to the steric hindrance between side chains. When the oxetanyl equivalent is more than 10,000 g/eq, the density of oxetanyl groups may be too low to allow the reaction to proceed.

In the case where the high molecular compound (A) contains a photopolymerization initiating group, the amount of the photopolymerization initiating group in the high molecular compound (A) is preferably 0.1 to 50 mol%. When the amount is less than 0.1 mol%, the photocurability may be impaired. When the amount is more than 50 mol%, the molecular weight may not increase due to excessive initiating groups, thereby impairing the photocurability.

Although the amount of the high molecular compound (A) in the photocurable resin sheet of the present invention is not limited, the amount is preferably 85% by mass or more, more preferably 88% by mass or more, still more preferably 92% by mass or more, particularly preferably 95% by mass or more, but is preferably 99% by mass or less, more preferably 98% by mass or less. When the amount is less than 85% by mass, the sheet shape may not be maintained at normal temperature. When the amount is 95% by mass or more, the storage modulus G' achieved tends to be better.

Low molecular compound (B)

The upper limit of the molecular weight of the low molecular compound (B) is not limited, but is preferably less than 1,000, more preferably 800 or less, still more preferably 700 or less. A low molecular compound (B) having a molecular weight of 1,000 or more may show a lower diffusion rate in the system, thereby impairing the photocurability. The lower limit of the molecular weight is also not limited, but is preferably 100 or more, more preferably 400 or more. The low molecular compound (B) may be a single compound or a combination of two or more compounds.

As used herein, the molecular weight of the low molecular compound is calculated from the molecular structure of the compound. The molecular structure of the compound herein is determined by NMR.

The low molecular compound (B) may contain all of the epoxy, oxetanyl, and photopolymerization initiating groups. Alternatively, the low molecular compound (B) may contain only some of these substituents or none of these substituents. These substituents may be present in both the high molecular compound (A) and the low molecular compound (B), but the substituent(s) not present in the low molecular compound (B) should be present in the high molecular compound (A). In the case where the low molecular compound (B) contains multiple such substituents, the low molecular compound (B) does not need to be a single compound containing the multiple substituents and may be a combination of multiple compounds each containing one of the substituents. Among these substituents, the low molecular compound (B) preferably contains an oxetanyl group or a photopolymerization initiating group.

Examples of the low molecular compound (B) containing an epoxy group include aliphatic epoxy compounds, alicyclic epoxy compounds, and aromatic epoxy compounds. Preferred among these are alicyclic epoxy compounds.

Examples of the aliphatic epoxy compounds include glycidyl ethers of polyhydric alcohols such as 1,4-butanediol diglycidyl ether, 1,6-hexanediol diglycidyl ether, triglycidyl ether of glycerol, triglycidyl ether of trimethylolpropane, tetraglycidyl ether of sorbitol, hexaglycidyl ether of dipentaerythritol, diglycidyl ether of polyethylene glycol, and diglycidyl ether of polypropylene glycol; polyglycidyl ethers of polyether polyols obtained by addition of one or two or more alkylene oxides to aliphatic polyhydric alcohols (e.g., propylene glycol, trimethylolpropane, glycerol), diglycidyl esters of aliphatic long-chain dibasic acids, monoglycidyl ethers of aliphatic higher alcohols, glycidyl esters of higher fatty acids, epoxidized soybean oil, octyl epoxystearate, butyl epoxystearate, and epoxidized polybutadiene. These may be used alone or in combinations of two or more.

Examples of the alicyclic epoxy compounds include 3,4-epoxycyclohexylmethyl-3,4-epoxycyclohexane carboxylate, 3,4-epoxy-1-methylcyclohexyl-3,4-epoxy-1-methylhexane carboxylate, 6-methyl-3,4-epoxycyclohexylmethyl-6-methyl-3,4-epoxycyclohexane carboxylate, 3,4-epoxy-3-methylcyclohexylmethyl-3,4-epoxy-3-methylcyclohexane carboxylate, 3,4-epoxy-5-methylcyclohexylmethyl-3,4-epoxy-5-methylcyclohexane carboxylate, bis(3,4-epoxycyclohexylmethyl)adipate, 3,4-epoxy-6-methylcyclohexylcarboxylate, methylene-bis(3,4-epoxycyclohexane), propane-2,2-diyl-bis(3,4-epoxycyclohexane), 2,2-bis(3,4-epoxycyclohexyl)propane, dicyclopentadiene diepoxide, ethylene-bis(3,4-epoxycyclohexane carboxylate), 1-epoxyethyl-3,4-epoxycyclohexane, and 1,2-epoxy-2-epoxyethylcyclohexane. Also usable are caprolactone-modified products, trimethylcaprolactone-modified products, and valerolactone-modified products of the foregoing. These may be used alone or in combinations of two or more.

Examples of the aromatic epoxy compounds include monoglycidyl ethers of polyether alcohols obtained by addition of alkylene oxides to phenol, cresol, or butylphenol. These may be used alone or in combinations of two or more.

Examples of the low molecular compound (B) containing an oxetanyl group include 3-ethyl-3{[(3-ethyloxetan-3-yl)methoxy]methyl}oxetane, 3-methyl-3-hydroxymethyl oxetane, 3-ethyl-3-hydroxymethyl oxetane, 3-ethyl-3-(2-ethylhexyloxymethyl)oxetane, 1,4-bis[(3-ethyl-3-oxetanyl)methoxymethyl]benzene, 3-ethyl-3-(phenoxymethyl)oxetane, di[(3-ethyl-3-oxetanyl)methyl] ether, 3-ethyl-3-(2-ethylhexyloxymethyl)oxetane, phenol novolac oxetane, isobutoxymethyl (3-ethyl-3-oxetanylmethyl) ether, isobornyloxyethyl (3-ethyl-3-oxetanylmethyl) ether, isobornyl (3-ethyl-3-oxetanylmethyl) ether, 2-ethylhexyl (3-ethyl-3-oxetanylmethyl) ether, ethyl diethylene glycol (3-ethyl-3-oxetanylmethyl) ether, di[1-ethyl(3-oxetanyl)]methyl ether, 3,7-bis(3-oxetanyl)-5-oxa-nonane, 1,2-bis[(3-ethyl-3-oxetanylmethoxy)methyl]ethane, 1,3-bis[(3-ethyl-3-oxetanylmethoxy)methyl]propane, ethylene glycol bis(3-ethyl-3-oxetanylmethyl) ether, tricyclodecane diyl dimethylene (3-ethyl-3-oxetanylmethyl) ether, trimethylolpropane tris(3-ethyl-3-oxetanylmethyl) ether, 1,4-bis(3-ethyl-3-oxetanylmethoxy)butane, 1,6-bis(3-ethyl-3-oxetanylmethoxy)hexane, pentaerythritol tris(3-ethyl-3-oxetanylmethyl) ether, pentaerythritol tetrakis(3-ethyl-3-oxetanylmethyl) ether, polyethylene glycol bis(3-ethyl-3-oxetanylmethyl) ether, dipentaerythritol hexakis(3-ethyl-3-oxetanylmethyl) ether, dipentaerythritol pentakis(3-ethyl-3-oxetanylmethyl) ether, and dipentaerythritol tetrakis(3-ethyl-3-oxetanylmethyl) ether. These may be used alone or in combinations of two or more. Preferred among these is 3-ethyl-3{[(3-ethyloxetan-3-yl)methoxy]methyl}oxetane.

The low molecular compound (B) containing a photopolymerization initiating group may be any low molecular compound containing a group that will generate an ion pair or a radical by photoabsorption. Examples include photocationic polymerization initiators containing photocationic polymerization initiating groups and photoradical polymerization initiators containing photoradical generating groups.

The photocationic polymerization initiators, when irradiated with active energy rays such as visible light, ultraviolet light, X-rays, or electron beams, generate cationic species or Lewis acids, thereby initiating polymerization of an epoxy group and an oxetanyl group. Preferred among the photocationic polymerization initiators are photoacid generators or photobase generators, with photoacid generators being more preferred. When the active energy rays used are visible light rays, preferred are photocationic polymerization initiators particularly sensitive to light at 380 nm or longer. Photocationic polymerization initiators generally show maximum absorption at around 300 nm or shorter wavelengths. Thus, photosensitizers with maximum absorption of light in the range of longer wavelengths, specifically at a wavelength longer than 380 nm may be incorporated to allow the photocationic polymerization initiators to be sensitive to light at around such wavelengths, thereby promoting generation of cationic species or Lewis acids from the photocationic polymerization initiators.

Examples of the photoacid generators include onium salts containing anionic and cationic components. Examples of onium cationic components include aromatic diazoniums, aromatic sulfoniums, aromatic iodoniums, aromatic seleniums, aromatic pyridiniums, aromatic ferroceniums, and aromatic phosphoniums. Preferred among these are aromatic sulfoniums.

Examples of anionic components include $PF_6^-$, $PF_4(CF_2CF_3)_2^-$, $SbF_6^-$, $AsF_6^-$, $SbCl_6^-$, $BiCl_5^-$, $SnCl_6^-$, $ClO_4^-$, dithiocarbamate anions, $SCN^-$, and trifluoromethanesulfonate. Preferred among these are $PF_6^-$, $SbF_6^-$, and $AsF_6^-$, with $PF_6^-$ or $SbF_6^-$ being more preferred.

The low molecular compound (B) is more preferably a combination of a low molecular compound (B) containing an oxetanyl group and a low molecular compound (B) containing a photopolymerization initiating group. In particular, it is preferred to combine a high molecular compound (A) containing an epoxy group, a low molecular compound (B) containing an oxetanyl group, and a low molecular compound (B) containing a photopolymerization initiating group. More preferred is a combination of a high molecular compound (A) that is a poly(meth)acrylic resin containing an epoxy group, a low molecular compound (B) containing an oxetanyl group, and a low molecular compound (B) containing a photopolymerization initiating group. The low molecular compound (B) containing a photopolymerization initiating group is preferably a photocationic polymerization initiator, more preferably a photoacid generator, still more preferably an aromatic sulfonium salt.

The amount of the low molecular compound (B) in the photocurable resin sheet of the present invention is not limited, but is preferably 0.5 to 15% by mass, more preferably 1 to 12% by mass. The lower limit of the amount is still more preferably 2% by mass or more, while the upper limit is still more preferably 8% by mass or less, particularly preferably 5% by mass or less. When the amount is less than 0.5% by mass, the photocurability may be impaired. When the amount is more than 15% by mass, the low molecular compound (B) may bleed to the sheet surface, impairing the handleability. When the amount is 5% by mass or less, the storage modulus G' achieved tends to be better.

In the case where the low molecular compound (B) is a combination of a low molecular compound (B) containing an oxetanyl group and a low molecular compound (B) containing a photopolymerization initiating group, the amount of the low molecular compound (B) containing an oxetanyl group in the photocurable resin sheet is preferably 0.5 to 10% by mass, more preferably at least 0.5% by mass but less than 5% by mass. The upper limit of the amount is still more preferably 4% by mass or less. When the amount is less than 0.5% by mass, the photocurability may be impaired. When the amount is more than 10% by mass, the low molecular compound (B) may bleed to the sheet surface, impairing the handleability. In the case where the low molecular compound (B) is a combination of a low molecular compound (B) containing an oxetanyl group and a low molecular compound (B) containing a photopolymerization initiating group, the amount of the low molecular compound (B) containing a photopolymerization initiating group in the photocurable resin sheet is preferably 0.01 to 5% by mass, more preferably 0.05 to 2.5% by mass. When the amount is less than 0.01% by mass, the photocurability may be impaired. When the amount is more than 5% by mass, the low molecular compound (B) may bleed to the sheet surface, impairing the handleability or transparency.

The combined amount of the high molecular compound (A) and the low molecular compound (B) in the photocurable resin sheet of the present invention is preferably 90% by mass or more, more preferably 95% by mass or more, still more preferably 98% by mass or more, particularly preferably 99% by mass or more, and may be 100% by mass.

The photocurable resin sheet of the present invention may contain additional components in addition to the high molecular compound (A) and the low molecular compound (B) as long as the advantageous effect of the present invention is not impaired. Examples of such additional components include photosensitizers and colorants. These may be used alone or in combinations of two or more.

Examples of the photosensitizers include anthracene compounds, pyrene compounds, carbonyl compounds, organic sulfur compounds, persulfides, redox compounds, azo or diazo compounds, halogen compounds, and photoreducing dyes. These may be used alone or in combinations of two or more. Particularly preferred are anthracene compounds excellent in a photosensitizing effect. The amount of the photosensitizers is preferably 0.1 to 5% by mass, more preferably 0.5 to 3% by mass.

The photocurable resin sheet of the present invention preferably has a storage modulus G' at 25°C of 50,000 Pa or higher, more preferably 100,000 Pa or higher, still more preferably 200,000 Pa or higher, particularly preferably 300,000 Pa or higher, most preferably 400,000 Pa or higher, further most preferably 420,000 Pa or higher. The upper limit of the storage modulus G' is not limited, but is preferably 1,000,000 Pa or lower. When the storage modulus G' is lower than 50,000 Pa, the photocurable resin sheet may have poor handleability due to stickiness (tackiness). The storage modulus can be measured using a dynamic viscoelastometer.

Increasing the amount of the high molecular compound (A) in the photocurable resin sheet tends to provide a higher storage modulus G'. Also, the use of a high molecular compound (A) having a higher glass transition temperature tends to provide a higher storage modulus G'. Moreover, removing more residual solvent such as methyl ethyl ketone from the sheet tends to provide a higher storage modulus G'.

A cured product of the photocurable resin sheet of the present invention at 25°C preferably has an optical transmittance at a wavelength of 400 nm of 70% or higher, more preferably 80% or higher. The upper limit of the optical transmittance is not limited, but is preferably 99% or lower. When the optical transmittance is lower than 70%, the cured product may have insufficient transparency, failing to be usable in optical applications. The optical transmittance can be measured using a spectrophotometer.

The optical transmittance at a wavelength of 400 nm may be adjusted within the above range by reducing the photoabsorption in the UV region by the raw materials used.

The preferred range of the refractive index with respect to light at a wavelength of 589 nm of the cured product of the photocurable resin sheet of the present invention depends on the application of the photocurable resin sheet. For example, in the case where the photocurable resin sheet of the present invention is used in lenses, the refractive index is preferably 1.40 or higher, more preferably 1.47 or higher. The upper limit of the refractive index is not limited, but is preferably 1.80 or lower. The refractive index can be measured using a refractive index meter.

The refractive index with respect to light at a wavelength of 589 nm may be adjusted within the above range by varying the refractive indexes of the raw materials used and their compounding ratio.

As a specific method for adjusting the optical transmittance or refractive index within the above range, for example, materials with low photoabsorption in the UV region may be used and if necessary the amount of photoabsorbent materials (e.g., photopolymerization initiating group-containing compounds) may be adjusted to be small.

The photocurable resin sheet of the present invention may be prepared by casting a photocurable resin composition containing the above-described high molecular compound (A) and low molecular compound (B) and a solvent onto a substrate, and optionally drying the solvent. Alternatively, a photocurable resin composition containing the above-described high molecular compound (A) and low molecular compound (B) may be processed into a film using a roll or extruded through a T die into a film. Then, the substrate, if used, may or may not be separated. Moreover, another substrate may be further placed on the photocurable resin sheet prepared on the substrate to sandwich the photocurable resin sheet between the substrates. In this case, the photocurable resin sheet may be wound around a winding core into a roll. Alternatively, such sheets cut to a predetermined size may be stacked into a stack of sheets.

Any solvent may be used. Examples include esters such as ethyl lactate, methyl acetate, and butyl acetate, ketones such as acetone, methyl ethyl ketone, and methyl isobutyl ketone, polar solvents such as dimethylformamide and dimethyl sulfoxide, halogenated solvents such as 1,1,1-trichloroethane and chloroform, ethers such as tetrahydrofuran and dioxane, aromatic compounds such as benzene, toluene, and xylene, and fluorinated inert liquids such as perfluorooctane and perfluoro-tri-N-butylamine. These may be used alone or in combinations of two or more. Among these, methyl ethyl ketone is preferred from the standpoint of compatibility with the solute.

In the case where the photocurable resin composition contains a solvent, the amount of the solvent is not limited, but is preferably 20 to 50 parts by mass relative to 100 parts by mass in total of the above-described high molecular compound (A) and low molecular compound (B).

The substrate may be, for example, a plastic substrate, suitably a plastic film. The material of the plastic substrate is not limited, and examples include polyolefins, polyesters, polyurethanes, polycarbonates, polyether ether ketones, polyimides, polyether imides, polyamides, wholly aromatic polyamides, polyvinyl chlorides, polyvinylidene chlorides, polyphenyl sulfides, aramids, fluororesins, cellulosic resins, and silicone resins. Examples of the polyolefins include low-density polyethylene, linear low-density polyethylene, medium-density polyethylene, high-density polyethylene, very-low-density polyethylene, random copolymer polypropylene, block copolymer polypropylene, homopolypropylene, polybutene, polymethyl pentene, ethylene-vinyl acetate copolymers, ionomer resins, ethylene-(meth)acrylic acid copolymers, ethylene-(meth)acrylic acid ester copolymers, ethylene-butene copolymers, and ethylene-hexene copolymers. Examples of the polyesters include polyethylene terephthalate, polyethylene naphthalate, and polybutylene terephthalate. These materials may be used alone or in combinations of two or more. Moreover, the substrate may have a monolayer structure or a multilayer structure. Moreover, the substrate preferably has optical transparency.

The photocurable resin sheet of the present invention can be cured by photoirradiation such as irradiation with ultraviolet light (at a wavelength around 365 nm, for example). Examples of light sources for photoirradiation include LEDs, low-pressure mercury lamps, high-pressure mercury lamps, ultra-high-pressure mercury lamps, and xenon lamps. The irradiation dose is not limited, but is preferably 100 to 10,000 mJ/cm$^2$. Moreover, a heat curing step may be carried out, if needed. The heating conditions may be, for example, at 120 to 180°C for 5 to 60 minutes.

The photocurable resin sheet of the present invention preferably has a thickness (excluding the substrate thickness) of 10 to 1,000 μm, more preferably 50 to 500 μm. When the thickness of the photocurable resin sheet is less than 10 μm, the handleability may be impaired, while when the thickness is more than 1,000 μm, the photocurability may be impaired.

Moreover, the optical material of the present invention is obtained by curing the photocurable resin sheet of the present invention.

Non-limiting examples of the optical material include adhesives for displays or optical semiconductors, lenses, protective films, and other optical electronic components.

EXAMPLES

The present invention is more specifically described hereinbelow with reference to, but not limited to, examples. Hereafter, "part(s)" and "%" mean "part(s) by mass" and "% by mass", respectively, unless otherwise specified.

The materials used in the examples and comparative examples are listed below.

- High molecular compound (A)

Epoxy group-containing (meth)acrylic resin 1 (1HM2067 available from Taisei Fine Chemical Co., Ltd., weight average molecular weight 60,000, epoxy equivalent 433 g/eq, glass transition temperature 15°C, (meth)acrylic resin containing an aliphatic epoxy group (glycidyl (meth)acrylate group))
Epoxy group-containing (meth)acrylic resin 2 (1HM2072 available from Taisei Fine Chemical Co., Ltd., weight average molecular weight 60,000, epoxy equivalent 433 g/eq, glass transition temperature 0°C, (meth)acrylic resin containing an aliphatic epoxy group (glycidyl (meth)acrylate group))

- Low molecular compound (B)

Epoxy group-containing compound (3,4-epoxycyclohexylmethyl-3,4-epoxycyclohexane carboxylate, Celloxide 2021P available from Daicel Corporation, molecular weight 252)
Oxetanyl group-containing compound (3-ethyl-3{[(3-ethyloxetan-3-yl)methoxy]methyl}oxetane, OXT221 available from Toagosei Co., Ltd., molecular weight 214) Photopolymerization initiating group-containing compound (triarylsulfonium salt, CPI101A available from San-Apro Ltd., molecular weight 558, anion: $SbF_6^-$)

- Others

Thermal curing initiator (KAOLIZER No. 20 available from Kao Corporation, dimethylbenzylamine (DMBA))

Examples 1 to 4 and Comparative Examples 1 to 3

The components at the ratio (solid content ratio) shown in Table 1 were dissolved in methyl ethyl ketone to provide a photocurable resin composition. The photocurable resin composition was cast onto a PET film used as a substrate and dried to obtain a photocurable resin sheet having a thickness of about 100 μm. The photocurable resin sheet was evaluated in terms of the amount of heat generated during curing, handleability, storage modulus G', optical transmittance, and refractive index as described below. Table 1 shows the evaluation results.

<Amount of heat generated during curing>

A 5-mg sheet cut out from each of the photocurable resin sheets prepared in the examples and comparative examples was placed in an aluminum pan for reaction calorimetry (DSC) and continuously irradiated with Hg i-line at an illuminance of 10 mW under a stream of nitrogen, and the total amount of heat generated for up to 15 minutes following the start of irradiation was determined using a photoDSC device (EXSTAR6000 DSC available from Hitachi High-Tech Corporation). The larger the amount of heat generated during curing is, the better the photocurability is. An amount of heat generated during curing of not smaller than 10 mJ/mg is considered to indicate excellent photocurability.

<Handleability>

A contact test was performed on the surface of each photocurable resin sheet prepared in the examples and comparative examples, and the results were evaluated based on the following criteria.

Excellent: not sticky, no contact marks.
Good: sticky, but no adhesion of the photocurable resin composition.
Fair: sticky with slight adhesion of the photocurable resin composition.
Poor: very sticky with significant adhesion of the photocurable resin composition.

<Storage modulus G'>

The storage modulus G' of the photocurable resin sheets prepared in the examples and comparative examples was measured using a dynamic viscoelastometer HAAKE MARS (Ta Instruments, Inc.) under the following conditions.

Sample size: diameter 8 mmΦ, thickness 250 μm
Measurement mode: shear oscillation
Frequency: 1 Hz
Rate of temperature rise: 5°C/min

<Optical transmittance>

The photocurable resin sheets prepared in the examples and comparative examples were photocured by irradiation with ultraviolet light at a dose of 500 mJ/cm$^2$, followed by post-curing (at 150°C for 30 minutes). The optical transmittance (at a wavelength of 400 nm) of the cured products at 25°C was measured using a spectrophotometer (JASCO Corporation).

<Refractive index>

The photocurable resin sheets prepared in the examples and comparative examples were photocured by irradiation with ultraviolet light at a dose of 500 mJ/cm$^2$, followed by post-curing (at 150°C for 30 minutes). The refractive index with respect to sodium D-line (light at a wavelength of 589 nm) of the cured products was measured in a 25°C envoirment using a refractive index meter (Atago Co., Ltd.).

[Table 1]

| Example number | | Example 1 | Example 2 | Example 3 | Example 4 | Comparative Example 1 | Comparative Example 2 | Comparative Example 3 |
|---|---|---|---|---|---|---|---|---|
| High molecular compound (A) | Epoxy group-containing (meth)acrylic resin 1 | 10 | - | 10 | 10 | 10 | - | 10 |
| | Epoxy group-containing (meth)acrylic resin 2 | - | 10 | - | - | - | - | - |
| Low molecular compound (B) | Epoxy group-containing compound | - | - | - | - | - | 1 | - |
| | Oxetanyl group-containing compound | 1 | 1 | 0.3 | 0.1 | 1 | 1 | - |
| | Photopolymerization initiating group-containing compound | 0.2 | 0.2 | 0.2 | 0.2 | - | 0.2 | - |
| Others | Thermal curing initiator | - | - | - | - | - | - | 0.2 |
| Amount of heat generated during curing Q (mJ/mg) | | 35.4 | 49.0 | 14.6 | 11.3 | 0.4 | 184.0 | 0.2 |
| Handleability | | Excellent | Good | Excellent | Excellent | Excellent | Poor | Excellent |
| Storage modulus G' (25°C) (Pa) | | 410000 | 110000 | 440000 | 440000 | 410000 | Not measurable | 410000 |
| Optical transmittance (%) (400nm) | | 90 | 90 | 90 | 90 | Not measurable | Not measurable | 90 |
| Refractive index (589 nm) | | 1.49 | 1.49 | 1.49 | 1.49 | Not measurable | Not measurable | 1.49 |

INDUSTRIAL APPLICABILITY

The present invention relates to a photocurable resin sheet which can be used in optical electronic component applications including adhesives for displays or optical semiconductors, lenses, and protective films.

**Claims**

1.  A photocurable resin sheet, comprising a high molecular compound (A) and a low molecular compound (B), wherein an epoxy group, an oxetanyl group, and a photopolymerization initiating group are each individually present in the high molecular compound (A) or the low molecular compound (B).

2.  The photocurable resin sheet according to claim 1, wherein the high molecular compound (A) has a weight average molecular weight of 1,000 to 1,000,000.

3.  The photocurable resin sheet according to claim 1 or 2, wherein the low molecular compound (B) has a molecular weight of less than 1,000.

4.  The photocurable resin sheet according to any one of claims 1 to 3, wherein the photocurable resin sheet has a storage modulus G' at 25°C of 50,000 Pa or higher.

5.  The photocurable resin sheet according to any one of claims 1 to 4, wherein a cured product of the photocurable resin sheet at 25°C has an optical transmittance at a wavelength of 400 nm of 70% or higher and a refractive index with respect to light at a wavelength of 589 nm of 1.40 or higher.

6.  The photocurable resin sheet according to any one of claims 1 to 5, wherein the high molecular compound (A) comprises at least one selected from the group consisting of poly(meth)acrylic resins, phenoxy resins, polyurethane resins, silicone resins, polyester resins, polyamide resins, and polyimide resins.

7.  The photocurable resin sheet according to any one of claims 1 to 6, wherein the low molecular compound (B) comprises a compound containing an oxetanyl group.

8.  The photocurable resin sheet according to any one of claims 1 to 7, wherein the low molecular compound (B) comprises a photoacid generator.

9.  An optical material obtained by curing the photocurable resin sheet according to any one of claims 1 to 8.

## EUROPEAN SEARCH REPORT

Europäisches
Patentamt
European
Patent Office
Office européen
des brevets

**Application Number**

EP 21 21 2514

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | JP 2017 141356 A (NITTO DENKO CORP) 17 August 2017 (2017-08-17) * claims 1-4 * * tables 1,2 * * paragraph [0044] * | 1,3-5, 7-9 | INV. C08G59/68 C08G65/18 C09D171/02 C09D133/06 |
| X | B. CHI ET AL: "The effect of oxetane as active diluent on cationic UV curing system of fluorine-containing epoxy prepolymer", HINDAWI ADVANCES IN POLYMER TECHNOLOGY, vol. 2020, 6120354, 13 June 2020 (2020-06-13), pages 1-8, XP002806223, * table 2 * * section 2.4 - sample preparation; page 3 * | 1-8 | |
| X | US 5 882 842 A (AKAKI YU [JP] ET AL) 16 March 1999 (1999-03-16) * claims 1-11 * * tables 1,2 * * column 8, line 10 - line 50 * | 1-6,8 | |

**TECHNICAL FIELDS SEARCHED (IPC)**

C09D
C08L
C08G

The present search report has been drawn up for all claims

| Place of search | Date of completion of the search | Examiner |
|---|---|---|
| The Hague | 14 April 2022 | O'Sullivan, Timothy |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 21 21 2514

This annex lists the patent family members relating to the patent documents cited in the above-mentioned European search report.
The members are as contained in the European Patent Office EDP file on
The European Patent Office is in no way liable for these particulars which are merely given for the purpose of information.

14-04-2022

| Patent document cited in search report | | Publication date | Patent family member(s) | | Publication date |
|---|---|---|---|---|---|
| JP 2017141356 | A | 17-08-2017 | JP 6833169 B2 | | 24-02-2021 |
| | | | JP 2017141356 A | | 17-08-2017 |
| US 5882842 | A | 16-03-1999 | GB 2310211 A | | 20-08-1997 |
| | | | KR 970061930 A | | 12-09-1997 |
| | | | US 5882842 A | | 16-03-1999 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017141356 A
- JP 2015096571 A